# EUROPEAN PATENT APPLICATION

(11) **EP 2 792 724 A1**
(43) Date of publication of application: **22.10.2014**
(21) Application number: 13185266.7
(22) Date of filing: 20.09.2013
(51) Int. Cl.: C09J 7/02, C09J 11/08, G02F 1/1335, H01L 51/00, C09J 11/00, C08J 3/24, C09J 129/04, H01L 51/52, H01L 27/32

(54) **Adhesive, adhesive tape and pre-product of an organic light emitting display device comprising an adhesive layer formed by the adhesive**

(30) Priority: 15.04.2013 KR 20130040939
(71) Applicant: Samsung Display Co., Ltd., Yongin-City, Gyeonggi-Do, 446-711 (KR)
(72) Inventor: Kim, Jae-Hyun, Asan-si, Chungcheongnam-do 336-727 (KR); Huh, Myung-Soo, Suwon-si, Gyeonggi-do 443-719 (KR)
(74) Representative: Gulde & Partner

(57) **Abstract**

The present invention relates to an adhesive including adhesive capsules, an adhesive tape including the adhesive and a pre-product of an organic light emitting display device comprising an adhesive layer formed by the adhesive. The adhesive comprises a polymer matrix (310); and a plurality of adhesive capsules (320) dispersed in the polymer matrix (310). Each of the adhesive capsules (320) comprises a shell (321) configured to shatter under pressure, and an adhesive polymer (322) in the shell (321.)

## Description

The present invention relates to an adhesive including adhesive capsules, an adhesive tape including the adhesive and a pre-product of an organic light emitting display device comprising an adhesive layer formed by the adhesive.

### DESCRIPTION OF THE RELATED ART

A variety of components are used in the manufacturing of an electronic apparatus, and a product is completed by the combination of such components. There are many methods to combine the components, and one of the methods is an adhesion method using an adhesive.

For example, in the manufacture of a display device such as an organic light emitting display device, components thereof are combined by using an adhesive. In cases when a touch panel is used in the display device, the touch panel is generally attached between a window and a display panel, and an adhesive is used to bond the touch panel to the window or to the display panel.

In order to bond a touch panel to a window or to a display panel, optically clear adhesive (OCA), photocurable resin, or the like, is generally used. In the case of the photocurable resin, there may be a problem in that the photocurable resin flows down during a process of adhesion because it is a liquid phase material. In the case when a commercially available conventional OCA is used, because the conventional OCA is very sticky, it may be difficult to rework even when a defect is found because the components are not easily detached from each other once they are bonded. For example, when a conventional OCA is used in a process of manufacturing an organic light emitting display device to bond a touch panel to a display panel, it may be difficult to detach the touch panel from the display panel in order to perform a rework due to, for example, a misalignment and the like. That is, because the conventional OCA is very sticky, detachment does not occur between the touch panel and the display panel, which are bonded through use of the OCA, whereas a detachment may occur in a place where adhesion strength is relatively low, for example, at an emission layer or at a thin film encapsulation layer, or the like, which may cause a defect of a product.

### SUMMARY

The present invention is directed toward an adhesive that makes it easy to rework an organic light emitting display device and that does not cause a problem of adhesive flowing. An initial adhesion strength of the adhesive is weak, but the adhesion strength is capable of being increased by pressurization.

The inventive adhesive is defined in claim 1.

Further, the present invention is directed toward an adhesive tape using the adhesive, and provides a pre-product for an organic light emitting display device comprising an adhesive layer formed by the adhesive.

Further embodiments of the invention could be learned from the dependent claims and following description.

### BRIEF DESCRIPTION OF THE DRAWINGS

FIG. 1 is a schematic diagram showing a structure of a pre-product of an organic light emitting display device.
FIG. 2 is a schematic diagram illustrating a structure of an adhesive capsule.
FIG. 3 is a diagram illustrating a manufacturing process step of bonding a touch panel to a window.
FIG. 4 is a diagram schematically illustrating a structure of an adhesive tape.
FIG. 5 is a schematic diagram illustrating an organic light emitting display device.
FIGS. 6A to 6G are schematic diagrams illustrating a manufacturing process of an organic light emitting display device.

### DETAILED DESCRIPTION

Hereinafter, embodiments of the present disclosure will be described in more detail with reference to the accompanying drawings.

For reference, respective components and shapes thereof are schematically drawn or exaggeratedly drawn, or some components are omitted in the accompanying drawings for easy understanding. Like reference numerals designate like elements throughout the drawings.

Further, it will be understood that when a layer or an element is described as being "on" another layer or element, it may be directly disposed on another layer or element, or an intervening layer or element may also be present.

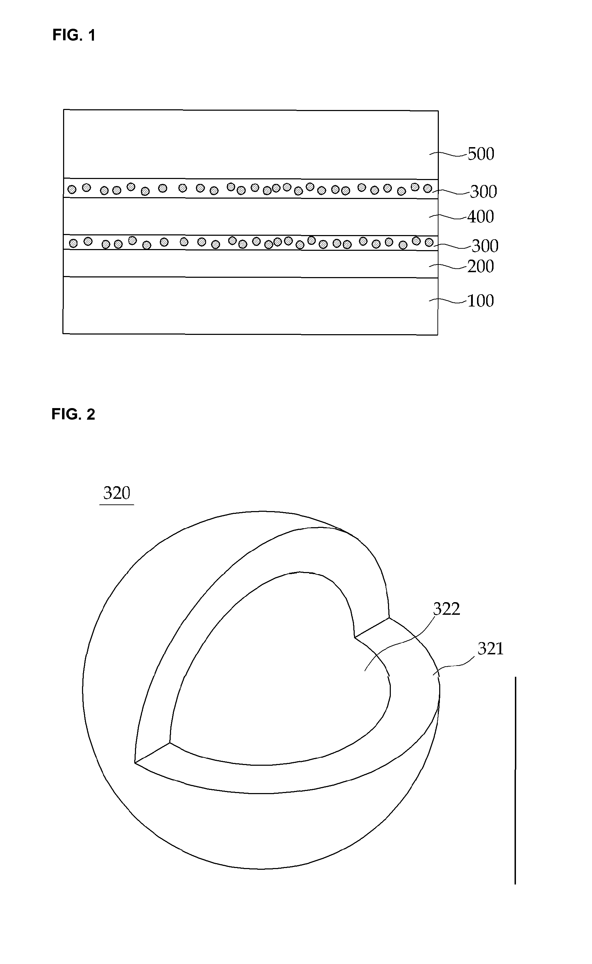

According to Fig. 1 a pre-product of an organic light emitting display device includes a substrate 100, a display unit (or display region) 200 disposed (or located) on the substrate 100, a touch panel 400 disposed on the display unit 200, an adhesive layer 300 disposed on the touch panel 400, and a window 500 disposed on the adhesive layer 300. Here, the adhesive layer 300 has a structure in which adhesive capsules 320 are dispersed in a polymer matrix 310, and the adhesive capsules 320 comprise shells 321, which are able to be destroyed under pressure, and adhesive polymer 322 contained in the shells 321.

In the organic light emitting display device illustrated in FIG. 1, an adhesive layer 300 is also disposed between the display unit 200 and the touch panel 400.

The adhesive layer 300 is formed by an adhesive.

The adhesive comprises a polymer matrix 310 and an adhesive capsule 320 dispersed in the polymer matrix 310. Here, the adhesive capsule 320 comprises a shell 321, which is able to be destroyed under pressure, and an adhesive polymer 322 contained in the shell 321.

In the adhesive comprising the polymer matrix 310 and the adhesive capsule 320, adhesion strength of the polymer matrix 310 is lower than that of a common adhesive, and in particular, is lower than that of the adhesive polymer 322 existing inside the adhesive capsule 320.

Hence, a material of which adhesion strength is lower than the adhesion strength of the adhesive polymer 322 is used as the polymer matrix 310. As a result, rework may be easy in a process of bonding/de-bonding components.

For example, the adhesive has a structure in which the adhesive capsule 320 is dispersed in the polymer matrix 310, and low adhesion is provided by the polymer matrix 310 before the adhesive capsule 320 is destroyed. That is, the adhesion strength of the adhesive is very weak before the adhesive capsule 320 is destroyed (e.g., broken or shattered) and the adhesive polymer 322 contained in the adhesive capsule 320 is released

In the case when an adhesive according to the present disclosure is used, in a state when two components are simply stacked, or weakly bonded, to each other, it is checked (or determined) whether or not a position where the components are stacked/bonded to each other is correct (e.g., whether the components are properly aligned, or a bonding state of the components is satisfactory), and thereafter, if a problem arises, the two components may be separated from each other easily. Hereinafter, a state of the two components simply stacked or weakly bonded to each other is called "initial adhesion," and the adhesive disposed between the two components forms the adhesive layer 300.

If a problem is not found in the bonding state of the two components, in other words, if it is not necessary to rework, pressure is applied to the adhesive layer 300 formed by the adhesive so that the adhesive capsules 320 inside the adhesive layer 300 are destroyed (e.g., broken or shattered). As a result, the adhesive polymer 322 inside the adhesive capsule 320 is released, thereby increasing the adhesion strength of the adhesive layer, and thus a stable adhesion is obtained.

As described above, the use of the adhesive according to the present disclosure increases (or improves) reworkability. Also, when the process is successfully completed, a stable adhesion may be obtained by applying pressure to the adhesive layer formed by the adhesive.

The polymer matrix 310 and the adhesive polymer 322 are selected from materials having an adhesive property (e.g., a predetermined adhesive property).

An adhesion force may be measured according to a conventional method for measuring adhesion. For example, a material having adhesiveness is disposed on a substrate to form an adhesive tape having an adhesive layer which is made of the material having adhesiveness; the adhesive tape adheres to a glass so that the adhesive layer is bonded to the glass, and an adhesion strength is measured by measuring a force required to peel the adhesive tape from the glass in a 180 degree direction under a condition of room temperature and an atmospheric pressure. The adhesion strength is sometimes called peel strength. Hereinafter, the adhesion strength according to the present disclosure is measured based on the above method.

The adhesion strength of the polymer matrix 310 is lower than that of conventional adhesives such as commercially available OCA, and for instance, the polymer matrix 310 may have adhesion strength in a range from 1.6 gf/cm to 2.8 gf/cm.

If the adhesion strength of the polymer matrix 310 is lower than 1.6 gf/cm, the adhesion strength is too weak and an initial adhesion is not easily achieved; and, if the adhesion strength of the polymer matrix 310 is higher than 2.8 gf/cm, it is not easy to rework.

Any material that are within the range for the adhesion strength of the polymer matrix 310 in a range from 1.6 gf/cm to 2.8 gf/cm may be used as the material for the polymer matrix 310 without limit. Because adhesion strength of a polymeric material may be regulated by adjusting a functional group, degree of polymerization, or the like, a polymeric material is used as the material of the polymer matrix 310. In the case when the adhesive is used to manufacture a display device, a transparent material may be used as the material of the polymer matrix 310.

An example of the material of the polymer matrix 310 is polyvinyl alcohol (PVA). Adhesion strength of PVA may be regulated by adjusting a functional group, degree of polymerization, or the like.

The adhesive also comprises the adhesive capsule 320 which is dispersed in the polymer matrix 310. The adhesive capsule 320, as illustrated in FIG. 2, comprises a shell 321, which is able to be destroyed under pressure, and an adhesive polymer 322 contained in the shell 321. The adhesive capsule 320, which is exemplified in FIG. 2 is spherical, however, the shape of the adhesive capsule 320 is not limited to the spherical shape and may have various suitable shapes such as a shape of a rugby ball and the like. Considering the shell 321 separately, the shell 321 has a hollow structure so that different materials may be contained therein, and the shell 321 is destroyed at a pressure which is higher than a set pressure (e.g., a predetermined pressure). The shell 321 may be formed by an organic or an inorganic material. The shell may be manufactured by using a material selected from the group consisting of gelatin, gum arabic, sodium alginate, carboxymethyl cellulose, ethyl cellulose, polyvinyl alcohol, nylon, polyurethane, polyester, epoxy, melamine-formalin, wax, and colloidal silica, or by mixing materials selected therefrom.

The adhesive polymer 322 is contained in the shell 321. The adhesive polymer 322 has adhesion strength which is higher than that of the polymer matrix 310. The adhesion strength of the polymer matrix 310 is lower than that of conventional adhesives, whereas the adhesive polymer 322 may be selected from materials having a similar level of adhesion strength compared to the adhesives conventionally used in the art. That is, the adhesive polymer 322 may be selected from the materials having a similar adhesion strength to those of adhesives which are conventionally used to bond components in the process of manufacturing electronic apparatuses or display devices.

For example, the adhesive polymer 322 may be selected from the materials having adhesion strength in a range of 350 gf/cm to 1,300 gf/cm.

For instance, the adhesive polymer 322 may comprise at least one selected from the group consisting of acrylic resin, rubber resin, gum resin, ethylene vinyl acetate (EVA) resin, nitrile resin, silicone resin, styrene block copolymer (SBC), and vinyl ether. The adhesion strength of the adhesive polymer 322 may also be regulated by adjusting a functional group, degree of polymerization, or the like.

The adhesive polymer 322 may be selected by a person skilled in the art as necessary. It may be selected in consideration of a desired adhesion strength, manufacturing convenience, production cost, or the like, according to use. According to another embodiment of the present disclosure, a material having adhesion strength in a range from 500 gf/cm to 1,000 gf/cm may be used as the adhesive polymer 322. In one embodiment, when the material having such adhesion strength is used as the adhesive polymer 322, the adhesive polymer 322 remains in the shell 321 of the adhesive capsule 320, but flows out of the shell 321 when a sufficient pressure is applied thereto, and is dispersed into the polymer matrix 310, thus providing the adhesive layer with increased adhesion strength.

According to an embodiment, an acrylic resin is used as the adhesive polymer 322.

As the adhesive polymer 322, a photopolymerizable polymer may also be used. For instance, a material that may obtain adhesion property by photopolymerization may be used. In such a case, after initial bonding is performed by using the adhesive, the adhesive polymer 322 flows out of the adhesive capsule 320 by pressure, and a light is emitted thereon to provide a stable adhesion.

In one embodiment, with respect to the adhesive, the adhesive capsule 320 does not contribute to adhesion strength in a capsule state, and thus, if the number of the adhesive capsule 320 is too high (excessively increases), there is concern that the initial adhesion of the adhesive becomes too low. On the other hand, if the number of the adhesive capsule 320 is too low (excessively decreases), a function of the adhesive polymer contained in the adhesive capsule is insignificant, and thus it may be difficult for the adhesive to exhibit a stable adhesion even after the adhesive capsule 320 is destroyed. In this regard, according to an embodiment of the present disclosure, the adhesive capsules 320 are 10% to 90% of the total volume of the adhesive.

In the event that the adhesive is applied to optical products including a display device, the display device may not be affected by the adhesive capsule 320 in terms of visibility. In this regard, according to an embodiment of the present disclosure, a size of the adhesive capsule 320 is smaller than the wavelength of visible light so as to decrease (or prevent) deterioration of visibility due to scattering of light by the adhesive capsule 320. To this end, according to an embodiment of the present disclosure, the adhesive capsule 320 has a particle size of less than 380 nm. In addition, in consideration of efficiency in manufacturing the adhesive capsule 320, in one embodiment, the adhesive capsule 320 has a size of greater than 50 nm. That is, the adhesive capsule 320 may have a particle size in a range from 50 nm to 380 nm.

The shell 321 is destroyed at a pressure which is higher than a set pressure (e.g., a predetermined pressure). The adhesive polymer 322 contained in the shell 321 flows out of the shell 321 after the destruction of the shell 321, and is dispersed in the polymer matrix 310. As a result, after the destruction of the shell 321, the adhesive may have increased (or improved) adhesion strength as a whole, and thus a stable adhesion may occur.

The shell 321 has to be destroyed by applying pressure to two components bonded to each other by the adhesive. If the shell 321 is destroyed at a low enough pressure, there is concern that the shell 321 will be destroyed in an undesirable state. On the other hand, if a high enough pressure is used to destroy the shell 321, there is concern that components to which pressure is applied will be damaged in the process of applying the pressure to destroy the shell 321. In this regard, according to an embodiment of the present disclosure, the shell 321 is destroyed at a pressure of 0.35 MPa to 1 MPa. When a touch panel is bonded by using the adhesive in an organic light emitting display device, if the shell 321 is destroyed at the above ranged pressure, other parts of the organic light emitting display device may not be damaged.

Accordingly, almost all of or some of the shells 321 contained in the adhesive may be destroyed entirely or partially.

The pressure at which the shell 321 is destroyed may be regulated by adjusting materials of which the shell 321 is made, a thickness of the shell 321, a manufacturing method thereof, and the like. For example, a thickness of the shell 321 may be regulated. The thickness of the shell 321 varies depending on processing conditions, and the shell 321 may have a thickness so as to have a space in which the adhesive polymer 322 is contained.

The adhesive may be manufactured by a method comprising manufacturing an adhesive capsule 320 and dispersing the adhesive capsule 320 in a polymer matrix 310.

The adhesive capsule 320 may be manufactured by applying a method of manufacturing a core-shell structure. For example, the adhesive capsule 320 may be manufactured through steps of mixing a shell-forming material, a monomer for forming an adhesive polymer and a solvent, and stirring a mixture thereof (e.g., at a predetermined speed). In the process of mixing the shell-forming material and the monomer for forming the adhesive polymer with the solvent, a surfactant, a dispersion stabilizer, or the like, may be used. As the solvent, water, alcohol, or other organic solvents which are known may be used. The kinds of the solvent and the surfactant vary depending on the kinds of the shell-forming material and the monomer for forming the adhesive polymer.

The size of the adhesive capsule 320 or the thickness of the shell 321 may vary depending on the stirring speed. The stirring speed may be adjusted by a person skilled in the art. Adhesive ingredients selected from the group consisting of rubber, acrylic resin, silicone resin, and/or the like may be used, and desired properties may be obtained by regulating contents of the adhesive ingredients and the mixing process thereof.

The adhesive may be manufactured by using water, PVA as a material for the polymer matrix, cross-linking agent, additives, and the like. PVA may also play a role as a binder, and its property may vary depending on modification functional group, degree of polymerization, degree of saponification, concentration, and/or the like. Therefore, an adhesive suitable for an intended use may be manufactured by appropriately selecting the modification functional group, degree of polymerization, degree of saponification, concentration, and the like of PVA acting as the polymer matrix. The cross-linking agent may have an effect on adhesion strength of the adhesive. A person skilled in the art may select the cross-linking agent which is suitable for an intended use in consideration of adhesive property, optical property, processability, and/or durability. The kind and molecular weight of a material used to form a cross-linking agent may be controlled, and the contents of the cross-linking agent may also be controlled.

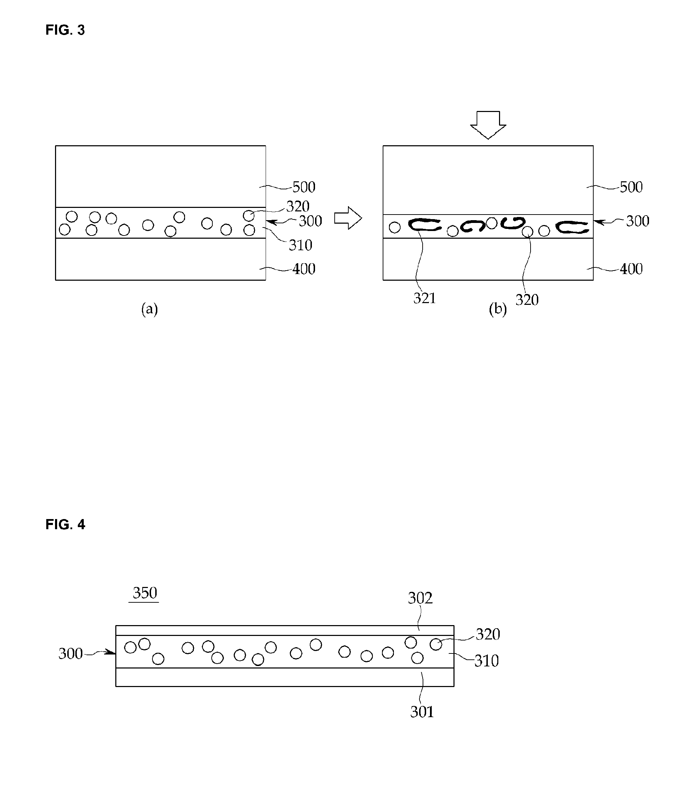

FIG. 3 illustrates the use of the adhesive layer 300 in order to bond the touch panel 400 to the window 500. Referring to FIG. 3, the adhesive is disposed between the touch panel 400 and the window 500 and functions as the adhesive layer 300.

For example, left section (a) of FIG. 3 represents a state in which the touch panel 400 and the window 500 are simply bonded to each other, namely an initial adhesion state, and the adhesive layer 300 made of the adhesive according to the present invention is disposed between the touch panel 400 and the window 500.

Here, methods for forming the adhesive layer 300 may include a method of coating the touch panel 400 or the window 500 with an adhesive of an embodiment of the present disclosure, and a method of using an adhesive tape to bond the touch panel 400 and the window 500.

After the initial adhesion, it is checked (or determined) whether the touch panel 400 and the window 500 are aligned at a desired position and whether there is any problem with the adhesion. If no problem is found, as illustrated in the right section (b) of FIG. 3, the touch panel 400 and the window 500 are pressed against each other so that pressure is applied to the adhesive layer 300. Due to the pressure, the shell 321 is destroyed, the adhesive capsule 320 dispersed in the adhesive layer 300 is destroyed, and the adhesive polymer 322 flows out of the adhesive capsule 320, and thus a stable adhesion may be obtained.

If the adhesive polymer is photopolymerizable, light is irradiated on the adhesive layer 320 so that an adhesion may be completed.

The adhesive according to an embodiment of the present disclosure may be used in a state of syrup or semi-fluid gel. In this case, the adhesive layer may be formed by coating a part with the adhesive.

The adhesive may be turned into a product in a form of a tape. That is, an embodiment of the present disclosure provides an adhesive tape having an adhesive layer formed by the adhesive. FIG. 4 schematically illustrates a structure of an adhesive tape 350.

The adhesive tape 350 comprises a base part (or a base) 301 in the form of a film, and an adhesive layer 300 disposed on the base part 301; the adhesive layer 300 comprises the before mentioned polymer matrix 310 and the before mentioned adhesive capsules 320 dispersed in the polymer matrix 310.

The type of the base part 301 is not particularly limited, and any suitable material that has been used for the base part of the adhesive tape may be applied to the base part without limit. For example, plastic, paper, non-woven fabric, and the like may be applied as the base part 301.

Further, a release liner 302 may be disposed on the adhesive layer 300. The kind of the release liner 302 is not particularly limited, and any release liner conventionally used in the art may be used without limit.

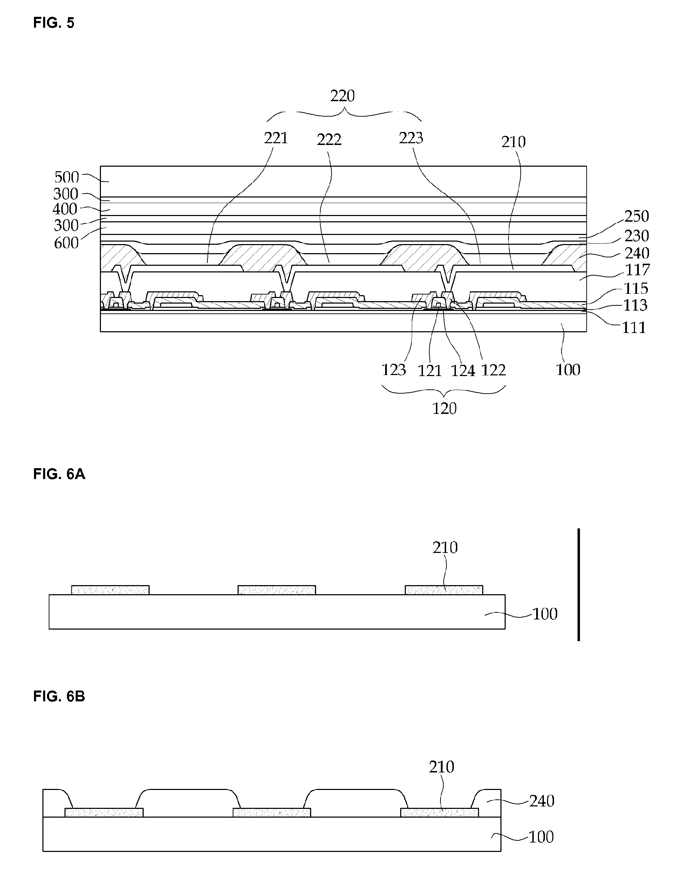

In the event that two components are bonded to each other by using the adhesive tape 350, in one embodiment, the adhesive layer 300 of the adhesive tape 350 is bonded to one component, the base part 301 is removed, and the other component may be bonded to a face of the adhesive layer 300, which is exposed by the removal of the base part 301. FIG. 5 illustrates an organic light emitting display device according to an embodiment of the present disclosure in more detail.

Referring to FIG. 5, an organic light emitting display device according to an embodiment of the present disclosure includes a substrate 100, a first electrode 210 disposed on the substrate 100, an emission layer 220 disposed on the first electrode 210, and a second electrode 230 disposed on the emission layer 220. Here, the first electrode 210, the emission layer 220, and the second electrode 230 belong to a display unit. In the display unit, a pixel defining layer 240 is disposed between the first electrodes 210. In FIG. 5, a protecting layer 250 is disposed on the second electrode 230. A part including the display unit comprising the substrate 100, the first electrode 210, the emission layer 220, the second electrode 230, and the protecting layer 250 is called a "display panel".

In addition, a polarizing film 600 is disposed on the protecting layer 250, and a touch panel 400 and a window 500 are disposed on the polarizing film 600, wherein adhesive layers 300 are disposed above and below the touch panel 400, and thus the touch panel 400 is bonded to the polarizing film 600 and the window 500.

The organic light emitting display device illustrated in FIG. 5 exemplifies a top emission organic light emitting display device, wherein light generated from the emission layer 220 is displayed to the second electrode 230 opposite to the substrate 100.

The adhesive layer formed by the adhesive according to an embodiment of the present disclosure may also be applied to a bottom emission organic light emitting display device, wherein light generated from the emission layer 220 is displayed to the substrate 100. In this case, the polarizing film 600, the touch panel 400, and the window 500 may be sequentially disposed on the substrate 100.

Hereinafter, a structure of an organic light emitting display device according to an embodiment of the present disclosure is explained in more detail, taking a top emission organic light emitting display device as an example.

First, as a substrate 100, glass or polymer plastic, which are conventionally used in an organic light emitting display device, may be used. The substrate 100 may be transparent or not. The substrate 100 may be appropriately selected by a person skilled in the art.

A first electrode 210 is formed on the substrate 100, and in advance of forming the first electrode 210, a plurality of thin film transistors 120 may be formed on the substrate 100. A thin film transistor 120 includes a gate electrode 121, a drain electrode 122, a source electrode 123, and a semiconductor layer 124, which are formed on the substrate 100. Also, the thin film transistor 120 may have a gate insulating layer 113 and an interlayer insulating layer 115. The thin film transistor 120 is not limited to the structure illustrated in FIG. 5, and may be configured in different forms. A buffer layer 111 formed, for example, of silicon oxide, silicon nitride, or the like may be further provided between the thin film transistor 120 and the substrate 100.

Referring to FIG. 5, the first electrode 210 is a pixel electrode electrically coupled to the thin film transistor 120 and serves as an anode, and the second electrode 230 is a common electrode and serves as a cathode.

The first electrode 210 is electrically coupled to the underlying thin film transistor 120 disposed below the first electrode 210, and if a planarization layer 117 covering the thin film transistor 120 is provided, the first electrode 210 is disposed on the planarization layer 117. Here, the first electrode 210 is electrically coupled to the thin film transistor 120 through a contact hole provided in the planarization layer 117.

The first electrode 210 may be a transparent or reflective electrode. When the first electrode 210 is a transparent electrode, it may be formed of indium tin oxide (ITO), indium zinc oxide (IZO), zinc oxide (ZnO), or indium(III) oxide (In₂O₃), and when it is a reflective electrode, it may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), or a combination thereof, and a layer formed of ITO, IZO, ZnO, or In₂O₃ on the reflective layer.

FIG. 5 illustrates that the first electrode 210 serves as an anode and the second electrode 230 serves as a cathode, alternatively the first electrode 210 may be a cathode and the second electrode 230 may be an anode.

Between the first electrodes 210, the pixel defining layer (PDL) 240 may be provided. The pixel defining layer 240 is formed of an insulating material and separates the first electrodes 210 into corresponding pixel units. For example, the pixel defining layer 240 may be disposed at the edges of the first electrodes 210 to separate the first electrodes 210 into corresponding pixel units, thereby defining pixel regions. The pixel defining layer 240 may cover the edges of the first electrode 210.

An emission layer 220 may be provided on the first electrode 210. The emission layer 220 is formed in the pixel regions which are openings formed on the first electrodes 210 separated by the pixel defining layer 240. The emission layer 220 may include, for example, a red emission layer 221, a green emission layer 222, and a blue emission layer 223, and may also include a white emission layer. Further, the emission layer 220 may have a structure in which red, green, and blue filters are respectively laminated on a layer made of a white light-emitting material.

At least one of a hole injection layer or a hole transporting layer may be further disposed between the first electrode 210 and the emission layer 220.

A second electrode 230 is disposed on the emission layer 220. The second electrode 230 may be made of a material conventionally used in the art. The second electrode 230 may be a transparent electrode in the top emission organic light emitting display device. When the second electrode 230 is a transparent electrode, it may include a layer formed of lithium (Li), calcium (Ca), lithium fluoride/calcium (LiF/Ca), lithium fluoride/aluminum (LiF/Al), Al, Mg, or a compound thereof, and a layer formed thereon, which consists of a transparent electrode-forming material such as ITO, IZO, ZnO, In₂O₃, or the like.

At least one of an electron injection layer or an electron transport layer may be further disposed between the emission layer 220 and the second electrode 230.

A protecting layer 250 may be disposed on the second electrode 230. The protecting layer 250 plays a role in protecting the underlying display unit, namely the first electrode 210, the emission layer 220, and the second electrode 230. As an example of the protecting layer 250, a capping layer or a thin film encapsulation layer may be formed. Both the capping layer and the thin film encapsulation layer may also be formed as the protecting layer 250.

A polarizing film 600 is disposed on an upper portion of the protecting layer 250. The polarizing film 600 plays a role in polarization of light, and may decrease (or prevent) external light reflection.

A touch panel 400 is disposed on the polarizing film 600. The touch panel 400 recognizes touch. The touch panel 400 and the polarizing film 600 are bonded to each other by an adhesive layer 300.

Further, a window 500 is disposed on the touch panel 400. The touch panel 400 and the window 500 are also bonded to each other by an adhesive layer 300. The adhesive layer 300 is formed by the adhesive according to an embodiment of the present disclosure.

FIGS. 6A to 6G illustrate a manufacturing process of an organic light emitting display device according to an embodiment of the present disclosure.

As illustrated in FIG. 6A, a first electrode 210 is formed on the substrate 100. The substrate 100 and the first electrode 210 are explained above. The first electrode 210 is patterned to form a pixel unit.

As illustrated in FIG. 6B, a pixel defining layer 240 separating the first electrode 210 by a pixel unit is formed.

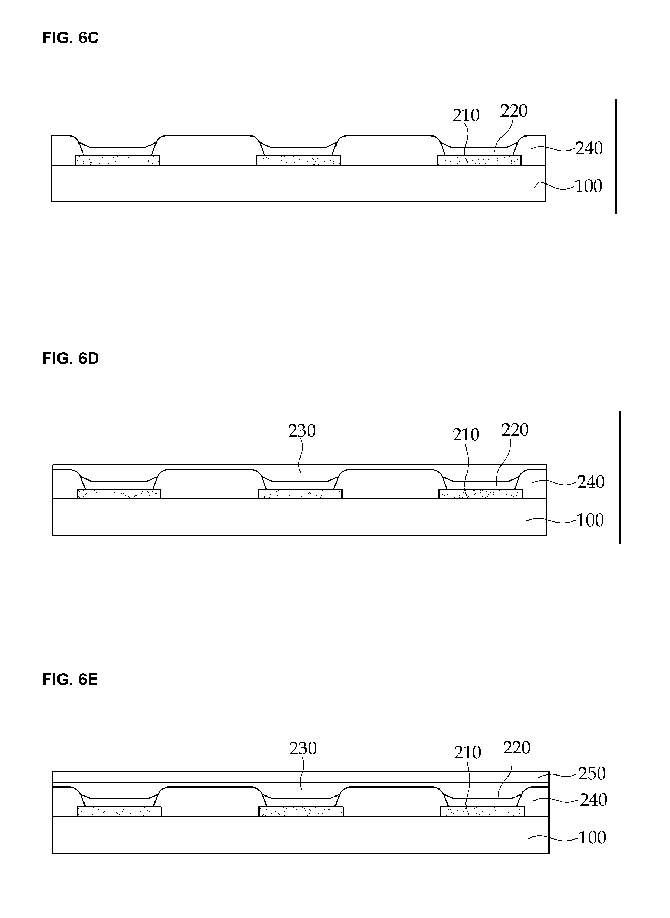

An emission layer 220 is formed at an opening of the first electrode 210 separated by the pixel defining layer 240 (FIG. 6C).

A second electrode 230 is formed over the surface of the pixel defining layer 240 and the emission layer 220 (FIG. 6D).

A protecting layer 250 is formed on the second electrode 230 (FIG. 6E). As the protecting layer 250, a capping layer may be formed or a thin film encapsulation layer having a multilayered structure may be formed. FIG. 6E exemplifies that a capping layer is formed as the protecting layer 250. As described above, a display panel is formed as shown in FIG. 6E.

A polarizing film may be disposed on the protecting layer 250.

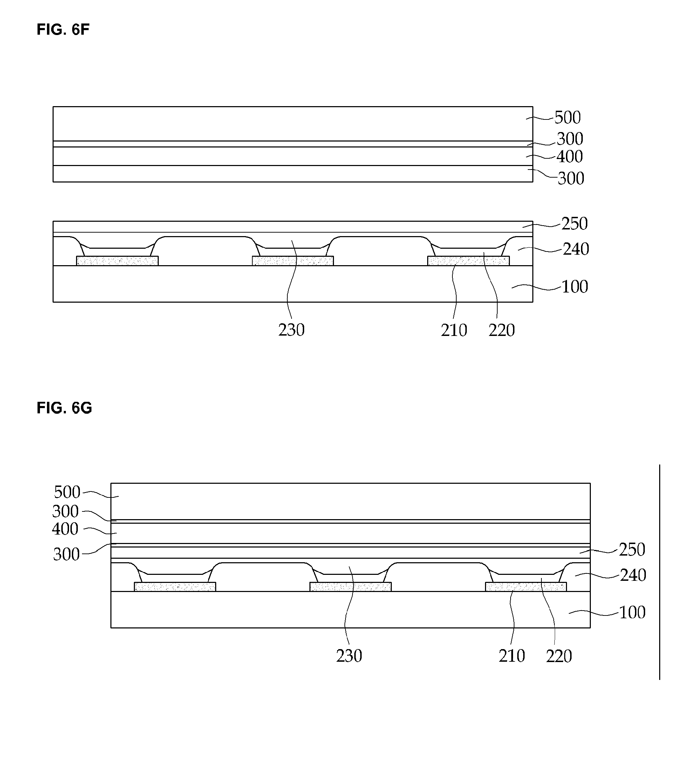

A touch panel 400 and a window 500 are disposed on the display panel where the protecting layer 250 is formed, as shown in FIG. 6F.

As an example of a method for bonding the touch panel 400 and the window 500 to the display panel, the touch panel 400 may be first bonded to the protecting layer 250, and then the window 500 may be bonded to the touch panel 400.

As another example, the touch panel 400 may be first bonded to the window 500, and then a bonded body including the touch panel 400 and the window 500 may be bonded to the display panel.

FIG. 6F exemplifies that the touch panel 400 may be first bonded to the window 500, and then the bonded body including the touch panel 400 and the window 500 may be bonded to the display panel.

Referring to FIG. 6F, the touch panel 400 and the window 500 are bonded to each other by utilizing an adhesive layer 300 formed by an adhesive according to an embodiment of the present disclosure. When the touch panel 400 and the window 500 are bonded to each other, it may undergo the process which is illustrated in FIG. 3, for example the rework and pressing process. In the process of bonding the touch panel 400 and the window 500, high reworkability may be provided because an adhesive layer 300 formed by an adhesive according to an embodiment of the present disclosure is applied to the process.

The bonded body including the touch panel 400 and the window 500 is disposed on the upper portion of the display panel so that the bonded body including the touch panel 400 and the window 500 may be bonded to the display panel (FIG. 6F).

FIG. 6F exemplifies that an adhesive layer 300 is disposed below the touch panel 400 so as to bond the bonded body including the touch panel 400 and the window 500 to the display panel. Alternatively, the adhesive layer 300 may be disposed on the protecting layer 250 of the display panel.

The bonded body including the touch panel 400 and the window 500 is positioned above the display panel, a bonding position is regulated so that the bonded body including the touch panel 400 and the window 500 may be properly aligned with the display panel, and the bonded body including the touch panel 400 and the window 500 is disposed on the display panel. This is not a state in which the adhesion is completed by the adhesion layer 300, but a state in which the bonded body including the touch panel 400 and the window 500 is simply stacked and weakly bonded to the display panel, namely an initial adhesion state. After the initial adhesion, it is checked (or determined) whether the bonded body and the display panel are aligned with each other at a desired position and whether any problem is involved in the adhesion.

Here, if the alignment is not correct or a problem is found in the adhesion, the bonded body including the touch panel 400 and the window 500 is capable of being detached from the display panel and the adhesion process capable of being reworked. The bonded body including the touch panel 400 and the window 500 may be easily detached from the protecting layer 250 of the display panel because the adhesive force of the adhesive layer 300 disposed between the touch panel 400 and the protecting layer 250 is not high. In the process of the detachment, no damage may be caused to other portions, such as the emission layer 220, the protecting layer 250, and the like.

If the alignment is correct and no problem is found in the adhesion, pressure is applied to the adhesive layer 300 from the window 500, and thus the bonded body including the touch panel 400 and the window 500 is bonded to the protecting layer 250 of the display panel. At this time, an adhesive capsule 320 dispersed in the adhesive layer 300 is destroyed and the adhesive polymer 322 flows out of the adhesive capsule 320, thereby providing a stable adhesion.

At this time, if the adhesive polymer is photopolymerizable, the adhesion may be completed by irradiating light on the adhesive layer 300.

As a result, an organic light emitting display device may be manufactured as illustrated in FIG. 6G.

## Claims

1. An adhesive comprising:
a polymer matrix (310); and
a plurality of adhesive capsules (320) dispersed in the polymer matrix (310),
wherein each of the adhesive capsules (320) comprises a shell (321) configured to shatter under pressure, and an adhesive polymer (322) in the shell (321).

2. The adhesive of claim 1, wherein the polymer matrix (310) comprises a material having an adhesion strength in a range from 1.6 gf/cm to 2.8 gf/cm.

3. The adhesive of claim 1 or claim 2, wherein the polymer matrix (310) comprises or consistes of polyvinyl alcohol (PVA).

4. The adhesive of any of the preceeding claims, wherein the shell (321) comprises or consits of a material selected from the group consisting of gelatin, gum arabic, sodium alginate, carboxymethyl cellulose, ethyl cellulose, polyvinyl alcohol, nylon, polyurethane, polyester, epoxy, melamine-formalin, wax, colloidal silica, and combinations thereof.

5. The adhesive of of any of the preceeding claims, wherein the shell (321) is configured to shatter at a pressure in a range from 0.35 MPa to 1 MPa.

6. The adhesive of of any of the preceeding claims, wherein the adhesive polymer (322) is configured to flow out of the shell and disperse within the polymer matrix (310) in response to the shell shattering.

7. The adhesive of any of the preceeding claims, wherein the adhesive polymer (322) comprises or consists of a material having an adhesion strength in a range from 350 gf/cm to 1,300 gf/cm.

8. The adhesive of any of the preceeding claims, wherein the adhesive polymer (322) includes or consists of a material selected from the group consisting of acrylic resin, rubber resin (gum resin), ethylene vinyl acetate (EVA) resin, nitrile resin, silicone resin, styrene block copolymer (SBC), vinyl ether, and combinations thereof.

9. The adhesive of any of the preceeding claims, wherein the adhesive polymer (322) has a photopolymerization property.

10. The adhesive of any of the preceeding claims, wherein the plurality of adhesive capsules (321) are 10 vol% to 90 vol% of the total volume of the adhesive.

11. The adhesive of any of the preceeding claims, wherein each adhesive capsule (321) has a particle size in a range from 50 nm to 380 nm.

12. An adhesive tape (350) comprising:
a base part (301) having a film form; and
an adhesive layer (300) on the base part (301),
wherein the adhesive layer (300) comprises an adhesive according to any of the preceeding claims.

13. The adhesive tape of claim 12, wherein the base part (301) comprises or consits of a material selected from the group consisting of plastic, paper, non-woven, and combinations thereof.

14. A pre-product of an organic light emitting display device comprising:
a substrate (100);
a display unit (200) on the substrate (100);
a touch panel (400) on the display unit (200);
an adhesive layer (300) on the touch panel (400); and
a window (500) on the adhesive layer (300),
wherein the adhesive layer comprises an adhesive according to any of claims 1 through 11.

15. The pre-product of claim 14, wherein the display unit (200) comprises a first electrode on the substrate, an emission layer on the first electrode, and a second electrode on the emission layer.
